# EUROPEAN PATENT APPLICATION

(11) **EP 2 112 762 A1**
(43) Date of publication of application: **28.10.2009**
(21) Application number: 09158299.9
(22) Date of filing: 21.04.2009
(51) Int. Cl.: H03H 7/00, H03H 7/38

(54) **Antenna matching unit and high-frequency receiving unit including the same**

(30) Priority: 22.04.2008 JP 2008111198; 21.10.2008 JP 2008270582
(71) Applicant: Panasonic Corporation, Kadoma-shi Osaka 571-8501 (JP)
(72) Inventor: Satoh, Yuki, Osaka-shi Osaka 540-6207 (JP)
(74) Representative: Grünecker, Kinkeldey, Stockmair & Schwanhäusser Anwaltssozietät

(57) **Abstract**

The invention provides an antenna matching unit including an antenna matching device to which a first high-frequency signal and a second high-frequency signal with a frequency higher than that of the first high-frequency signal are input; an active element to which an output signal from the antenna matching device is connected; and an output terminal to which an output from the active element is connected. The antenna matching device includes a signal line placed between the input and output; a series-connected element composed of a capacitor and inductor connected between the signal line and the ground; a capacitor connected in parallel with the inductor; and a control terminal for changing the capacitance value of the capacitor. The parallel resonance frequency between the inductor and capacitor is set to the frequency of the second high-frequency signal to reduce matching loss between the antenna and the tuner unit.

## Description

### BACKGROUND OF THE INVENTION

### 1. Field of the Invention

The present invention relates to an antenna matching unit receiving high-frequency signals included in two frequency ranges separated from each other by a small-size antenna and to a high-frequency receiving unit including the antenna matching unit.

### 2. Background Art

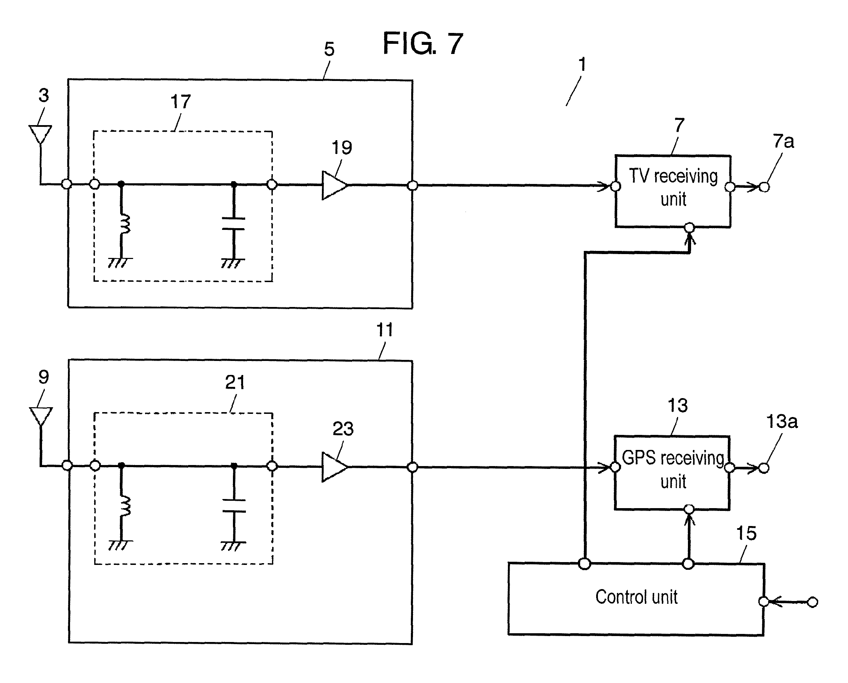

Fig. 7 is a block diagram of a conventional high-frequency receiving unit. In Fig. 7, high-frequency receiving unit 1 includes small-size TV antenna 3, receiving UHF TV broadcasting signals; antenna matching unit 5 connected to TV antenna 3; and TV receiving unit 7 connected to antenna matching unit 5. High-frequency receiving unit 1 further includes antenna 9 receiving GPS signals; antenna matching unit 11 connected to antenna 9; GPS receiving unit 13 connected to antenna matching unit 11; and control unit 15 controlling TV receiving unit 7 and GPS receiving unit 13.

Antenna matching unit 5 has antenna matching device 17 and amplifier 19 connected thereto in sequence from the input toward the output. In the same way, antenna matching unit 11 has antenna matching device 21 and amplifier 23 connected thereto in sequence from the input toward the output.

Hereinafter, a description is made of operation of high-frequency receiving unit 1 thus structured. A TV broadcasting signal received by TV antenna 3 is input to amplifier 19 through antenna matching device 17 reducing matching loss between itself and amplifier 19, and the TV broadcasting signal amplified is output from amplifier 19.

TV receiving unit 7 to which the TV broadcasting signal is input frequency-converts the TV broadcasting signal while controlling the gain, and further outputs an output signal with its disturbing signal suppressed from output terminal 7a.

A GPS signal received by GPS antenna 9 is input to amplifier 23 through antenna matching device 21 reducing matching loss between itself and amplifier 23, and the GPS signal amplified is output from amplifier 23. Further, the GPS receiving unit to which the GPS signal is input frequency-converts the signal while controlling the gain, and further outputs an output signal with its disturbing signal suppressed from output terminal 13a.

As information on prior art documents related to the invention of the application, Japanese Patent Unexamined Publication No. 2005-57735 is known.

However, such a conventional antenna matching device, when receiving high-frequency signals included in two frequency ranges separated from each other, is difficult to downsize because of including two antennas and two antenna matching units for supporting the respective high-frequency signals.

### SUMMARY OF THE INVENTION

The present invention implements an antenna matching unit, when receiving high-frequency signals having two frequency ranges separated from each other with a single small-size antenna, which reduces matching loss between a tuner unit or GPS receiving unit connected at a subsequent stage of the antenna.

An antenna matching unit according to the present invention is fed with a high-frequency signal including a first high-frequency signal having a first band width and a second high-frequency signal with a frequency higher than the first, having a second band width smaller than the first, by an antenna with a length of one-quarter or less the wavelength of the high-frequency signal. The antenna matching unit includes an input terminal to which the high-frequency signal from the antenna is input; an antenna matching device connected to the input terminal and minimizing the matching loss; an active element to which an output signal from the antenna matching device is connected and amplifying a high-frequency signal; and an output terminal to which the output from the active element is connected. The antenna matching device includes a signal line placed between the input terminal and the output terminal; a series-connected element composed of a first capacitor and a first inductor connected between the signal line and the ground; a second capacitor connected in parallel with the first inductor; and a control terminal for changing the capacitance value of the first capacitor. Further, the antenna matching unit changes the capacitance value of the first capacitor to reduce the matching loss for the first high-frequency signal, with the parallel resonance frequency between the first inductor and the second capacitor as the frequency of the second high-frequency signal.

### BRIEF DESCRIPTION OF DRAWINGS

Fig. 1 is a block diagram of a high-frequency receiving unit according to the first exemplary embodiment of the present invention.
Fig. 2A is a Smith chart showing the output impedance of the antenna and the input impedance of the active element, in the high-frequency receiving unit according to the first embodiment of the present invention.
Fig. 2B is a Smith chart showing the output impedance of the antenna and the input impedance of the active element, viewed from the antenna matching device in the high-frequency receiving unit according to the first embodiment of the present invention.
Fig. 2C is a Smith chart showing the output impedance of the antenna and the input impedance of the active element, viewed from the antenna matching device in the high-frequency receiving unit according to the first embodiment of the present invention.
Fig. 2D is a Smith chart showing the output impedance of the antenna and the input impedance of the active element, viewed from the antenna matching device in the high-frequency receiving unit according to the first embodiment of the present invention.
Fig. 3A is a matching property diagram of the antenna matching unit according to the first embodiment of the present invention, where the matching loss in the UHF low band is minimized.
Fig. 3B is a matching property diagram of the antenna matching unit according to the first embodiment of the present invention, where the matching loss in the UHF mid band is minimized.
Fig. 3C is a matching property diagram of the antenna matching unit according to the first embodiment of the present invention, where the matching loss in the UHF high band is minimized.
Fig. 4 is a circuit diagram of a distribution filter included in a high-frequency receiving unit according to the first embodiment of the present invention.
Fig. 5 is another circuit diagram of a distribution filter included in the high-frequency receiving unit according to the first embodiment of the present invention.
Fig. 6 is yet another circuit diagram of a distribution filter included in the high-frequency receiving unit according to the first embodiment of the present invention.
Fig. 7 is a block diagram of a conventional high-frequency receiving unit.

### DETAILED DESCRIPTION OF PREFERRED EMBODIMENTS

### FIRST EXEMPLARY EMBODIMENT

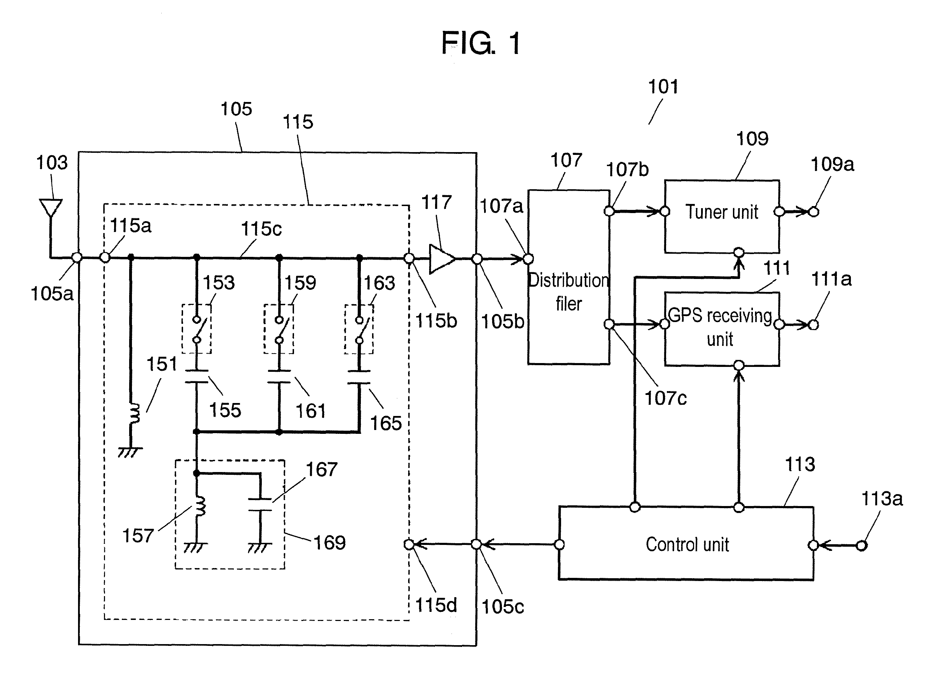

Fig. 1 is a block diagram of a high-frequency receiving unit according to the first exemplary embodiment. In Fig. 1, an assumption is made of a case of receiving a UHF TV broadcasting signal (first high-frequency signal) with a frequency of 470 to 770 MHz, with a band width of 6 MHz, and a GPS signal (second high-frequency signal) with a frequency of 1575.42 MHz, with a band width of 2.046 MHz, for example. High-frequency receiving unit 101 is composed of small-size antenna 103; antenna matching unit 105 connected to antenna 103 through input terminal 105a; distribution filter 107; tuner unit (first receiving unit) 109; GPS receiving unit (second receiving unit) 111; and control unit 113. Distribution filter 107 has its input terminal 107a connected to output terminal 105b of antenna matching unit 105 and separates the high-frequency signal into a UHF TV broadcasting signal and a GPS signal. Tuner unit 109 and GPS receiving unit 111 are connected to output terminals 107b, 107c of distribution filter 107, respectively. Control unit 113 controls antenna matching unit 105, tuner unit 109, and GPS receiving unit 111. From output terminals 109a, 111a, output from tuner unit 109 and GPS receiving unit 111 is output, respectively. Control data terminal 113a feeds control unit 113 with control data.

Antenna matching unit 105 is composed of input terminal 105a to which the output from antenna 103 is connected; antenna matching device 115 connected to input terminal 105a and reducing matching loss between itself and the antenna; active element 117 connected to the output from antenna matching device 115 and amplifying a high-frequency signal; output terminal 105b to which the output from active element 117 is connected; and control terminal 105c to which a control signal from control unit 113 is input.

Antenna matching device 115 is provided with input terminal 115a; output terminal 115b connected to input terminal 115a through signal line 115c; and control terminal 115d to which control data from control unit 113 is input. Further, between signal line 115c of antenna matching device 115 and the ground, inductor 151 used as a protection circuit against surge voltage; and a series-connected element composed of switch 153, capacitor 155, and inductor 157 are connected.

A series-connected element composed of switch 159 and capacitor 161; and a series-connected element composed of switch 163 and capacitor 165 are both connected in parallel with a series-connected element composed of switch 153 and capacitor 155. Further, inductor 157 has capacitor 167 connected in parallel therewith to form parallel resonance circuit 169. The parallel resonance frequency of the parallel resonance circuit is made approximately same as the frequency of the GPS signal.

Hereinafter, a description is made of operation of high-frequency receiving unit 101 thus structured. A high-frequency signal composed of a UHF TV broadcasting signal and a GPS signal received by antenna 103 is input to active element 117 through antenna matching device 115 minimizing matching loss between antenna 103 and subsequent-stage active element 117. Then, the high-frequency signal output from active element 117 is output from output terminal 105b.

The high-frequency signal having been output is input to distribution filter 107. From output terminal 107b of distribution filter 107, a UHF TV broadcasting signal is output, and from output terminal 107c, a GPS signal with a frequency of 1575.42 MHz is output.

The UHF TV broadcasting signal output from output terminal 107b is input to tuner unit 109. From output terminal 109a of tuner unit 109, a desired signal is output that has undergone frequency conversion, gain control, and removing of a disturbing signal.

Meanwhile, a GPS signal output from output terminal 107c of distribution filter 107 is input to GPS receiving unit 111. From output terminal 111a of GPS receiving unit 111, a desired signal is output that has undergone frequency conversion, gain control, and removing of a disturbing signal.

Control unit 113 selects a reception channel of tuner unit 109 and GPS receiving unit 111 according to control data input from control data terminal 113a, and further exercises control so that matching loss between antenna 103 and tuner unit 109 is minimized.

Next, a description is made of concrete operation of antenna matching unit 105 controlled by control unit 113 hereinafter.

Here, the description is made of a case where UHF broadcast signal 252a ranging from 470 to 770 MHz is divided into three bands: UHF low band 252b (low frequency band including 470 MHz), UHF mid band 252c (intermediate frequency band including 620 MHz), and UHF high band 252d (high frequency band including 770 MHz). Antenna 103 is a small-size antenna with a length of approximately 5 cm (one-quarter the wavelength) for receiving a GPS signal of 1575.42 MHz.

To receive a GPS signal, at least one of switches 153, 159, 163 is turned on according to a control signal from control unit 113. This operation allows parallel resonance circuit 169 to be connected between signal line 115c and the ground through at least either one of capacitors 155, 161, 165.

The parallel resonance frequency of parallel resonance circuit 169 is made approximately same as the frequency of a GPS signal.

To receive the UHF low band, switch 153 is turned on and switches 159, 163 are turned off according to a control signal from control unit 113.

This operation allows parallel resonance circuit 169 to be connected between signal line 115c of antenna matching device 115 and the ground through capacitor 155. For example, with the series resonance frequency produced by parallel resonance circuit 169 and capacitor 155 lower than a frequency in the UHF low band, the joint impedance of the series-connected circuit formed from parallel resonance circuit 169 and capacitor 155 in the UHF low band can be changed to inductance, which is inductive.

To receive the UHF mid band, switch 159 is turned on and switches 153, 163 are turned off according to a control signal from control unit 113. This operation allows parallel resonance circuit 169 to be connected between signal line 115c of antenna matching device 115 and the ground through capacitor 161.

For example, with the series resonance frequency produced by parallel resonance circuit 169 and capacitor 155 lower than the UHF mid band, the joint impedance of the series-connected circuit formed from parallel resonance circuit 169 and capacitor 155 in the UHF mid band can be changed to inductance, which is inductive.

To receive the UHF high band, switch 163 is turned on and switches 153, 159 are turned off according to a control signal from control unit 113. This operation allows parallel resonance circuit 169 to be connected between signal line 115c of antenna matching device 115 and the ground through capacitor 161.

For example, with the series resonance frequency produced by parallel resonance circuit 169 and capacitor 155 lower than the UHF high band, the joint impedance of the series-connected circuit formed from parallel resonance circuit 169 and capacitor 155 in the UHF high band can be changed to inductance, which is inductive.

Here, the capacitance value of capacitor 161 is set smaller than that of capacitor 155. The capacitance value of capacitor 165 is set smaller than that of capacitor 161.

This setting allows the joint impedance in the UHF mid band to be set smaller than that in the UHF low band; additionally the joint impedance in the UHF high band to be set smaller than that in the UHF mid band.

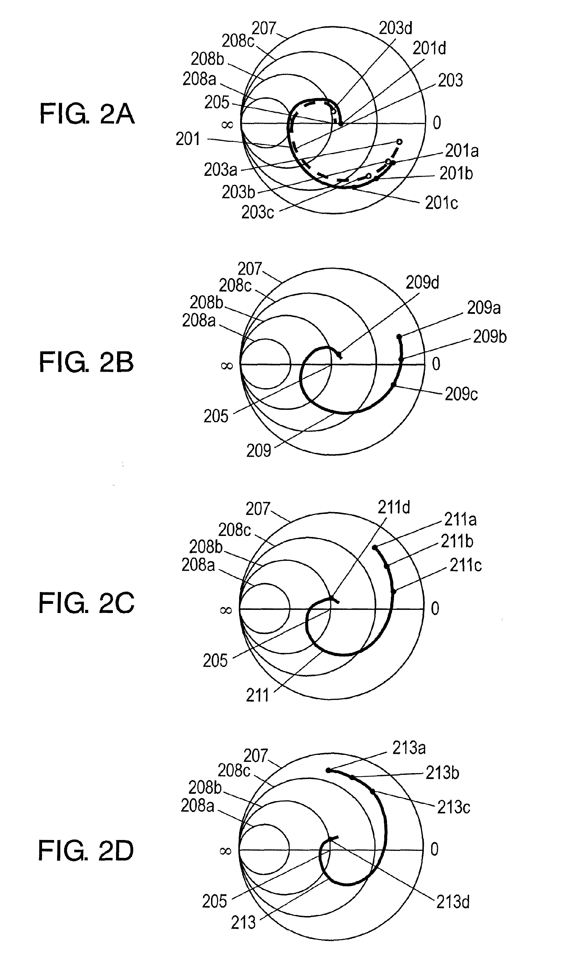

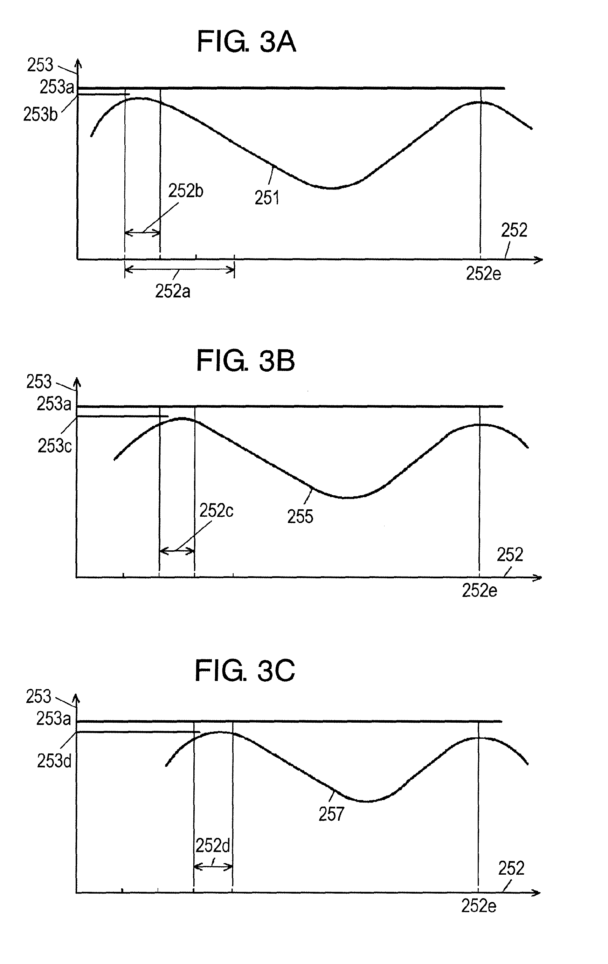

Fig. 2A is a Smith chart showing the output impedance of the antenna and the input impedance of the active element, in the high-frequency receiving unit according to the first embodiment of the present invention. Figs. 2B through 2D are Smith charts showing the output impedance of the antenna and the input impedance of the active element, viewed from the antenna matching device in the high-frequency receiving unit according to the first embodiment of the present invention. Fig. 3A is a property diagram of the matching loss in the UHF low band, of the antenna matching unit according to the first embodiment of the present invention. Fig. 3B is a property diagram of the matching loss in the UHF mid band, of the antenna matching unit according to the first embodiment of the present invention. Fig. 3C is a property diagram of the matching loss in the UHF high band, of the antenna matching unit according to the first embodiment of the present invention.

In Fig. 2A, output impedance 201 of antenna 103 is represented by a solid line; input impedance 203 of active element 117, by a dotted line. Here, constant conductance circles 208a, 208b, 208c represent conductances with different values, respectively. Antenna 103 is a small-size antenna with a length of approximately 5 cm (one-quarter the wavelength) for receiving a GPS signal of 1575.42 MHz. Accordingly, output impedance 203d of the antenna at a GPS frequency can be expressed by impedance 201d close to center 205.

On the other hand, output impedance 203d of the antenna at a frequency of a UHF TV broadcasting signal is known to separate from center 205 (i.e. 50 Ω) to approach outer circumferential circle 207. Consequently, output impedance 201a in UHF low band 252b; output impedance 201b in UHF mid band 252c; and output impedance 201c in UHF high band 252d are specified.

Meanwhile, input impedance 203 of active element 117, which can be expressed equivalently by capacitance and resistance (i.e. impedance 203a of UHF low band 252b, impedance 203b of UHF mid band 252c, impedance 203c of UHF high band 252d), approaches outer circumferential circle 207. Input impedance 203 of the antenna at the frequency of a GPS signal can be expressed by impedance 203d close to center 205, for example.

In this way, matching loss can be almost decreased at a GPS frequency. At a frequency of a UHF TV broadcasting signal, however, a large matching loss is generated because impedance 203 of antenna 103 is not conjugately complex to input impedance 203 of active element 117. Here, the input resistance of active element 117 is roughly the same as that of antenna 103.

Fig. 2B is a Smith chart showing the output impedance of the antenna and the input impedance of the active element, viewed from the antenna matching device in the high-frequency receiving unit according to the first embodiment of the present invention. Fig. 2B shows circumstances in which matching loss between antenna 103 and active element 117 is minimized by antenna matching device 115 in UHF low band 252b of Fig. 3A.

As shown in Fig. 2A, output impedance 201 of antenna 103 moves on the constant conductance circle counterclockwise due to inductance Llow inserted between signal line 115c and the ground. That is to say, in Fig. 2B, output impedance 209 expressed by impedance 209a in UHF low band 252b of Fig. 3A, impedance 209b in UHF mid band 252c of Fig. 3B, impedance 209c in UHF high band 252d of Fig. 3C, and impedance 209d in a GPS frequency is specified for antenna 103 viewed from antenna matching device 115.

Accordingly, output impedance 209a of antenna 103 viewed from antenna matching device 115 can be conjugately complex to input impedance 203a of active element 117 (refer to Figs. 2A, 2B). Herewith, matching loss between antenna 103 and active element 117 can be minimized in UHF low band 252b.

However, output impedances 209b, 209c of antenna 103 viewed from antenna matching device 115 cannot be conjugately complex to input impedances 203b, 203c of active element 117, which increases matching loss.

Fig. 2C is a Smith chart showing the output impedance of the antenna and the input impedance of the active element, viewed from the antenna matching device in the high-frequency receiving unit according to the first embodiment of the present invention. In UHF mid band 252c of Fig. 3B, Fig. 2C shows circumstances in which matching loss between antenna 103 and active element 117 is minimized by antenna matching device 115.

In Fig. 2A, output impedance 201 of antenna 103 moves on the constant conductance circle counterclockwise due to inductance Lmid inserted between signal line 115c and the ground. That is to say, in Fig. 2C, output impedance 211 expressed by impedance 211a in UHF low band 252b of Fig. 3A, impedance 211b in UHF mid band 252c of Fig. 3B, impedance 211c in UHF high band 252d of Fig. 3C, and impedance 211d in a GPS frequency is specified for antenna 103 viewed from antenna matching device 115.

Accordingly, output impedance 211b of antenna 103 viewed from antenna matching device 115 can be conjugately complex to input impedance 203b of active element 117 (refer to Figs. 2A, 2C). Herewith, matching loss between antenna 103 and active element 117 can be minimized in UHF mid band 252c.

However, output impedances 209a, 209c of antenna 103 viewed from antenna matching device 115 cannot be conjugately complex to input impedances 203a, 203c of active element 117, which increases matching loss.

Fig. 2D is a Smith chart showing the output impedance of the antenna and the input impedance of the active element, viewed from the antenna matching device in the high-frequency receiving unit according to the first embodiment of the present invention. In UHF high band 252d of Fig. 3C, Fig. 2D shows circumstances in which matching loss between antenna 103 and active element 117 is minimized by antenna matching device 115.

In Fig. 2A, output impedance 201 of antenna 103 moves on the constant conductance circle counterclockwise due to inductance Lhi inserted between signal line 115c and the ground. That is to say, in Fig. 2D, output impedance 213 expressed by impedance 213a in UHF low band 252b of Fig. 3A, impedance 213b in UHF mid band 252c of Fig. 3B, impedance 213c in UHF high band 252d of Fig. 3C, and impedance 213d in a GPS frequency is specified for antenna 103 viewed from antenna matching device 115.

Accordingly, output impedance 213a of antenna 103 viewed from antenna matching device 115 can be conjugately complex to input impedance 203c of active element 117 (refer to Figs. 2A, 2D). Herewith, matching loss between antenna 103 and active element 117 can be minimized in UHF high band 252d.

However, output impedances 209a, 209b of antenna 103 viewed from antenna matching device 115 cannot be conjugately complex to input impedances 203a, 203b of active element 117, which increases matching loss.

Here, all of impedances 209d, 211d, 213d of antenna 103 viewed from antenna matching device 115 move in the periphery of center 205 even in UHF low band 252b, UHF mid band 252c, and UHF high band 252d. Accordingly, matching loss can be always minimized.

Thus controlling switches 153, 159, 163 of antenna matching device 115 according to a control signal from control unit 113 allows matching loss between antenna 103 and active element 117 to be minimized correspondingly to UHF low band 252b, UHF mid band 252c, and UHF high band 252d, respectively.

Here, active element 117 typically can be a bipolar transistor or FET. On this occasion, the variable range of the inductance of a series resonance circuit formed from parallel resonance circuit 169 and capacitors 155, 161, 165 of antenna matching device 115 is desirably around 10 to 50 nH to support UHF TV broadcasting signals (470 to 770 MHz).

Fig. 3A is a matching property diagram of antenna matching unit 105 according to the first embodiment of the present invention, where matching loss 253b in UHF low band 252b is minimized. In Fig. 3A, the horizontal axis represents frequency 252; the vertical axis, loss 253; and loss 253a, a state of small loss.

Matching property 251 provides a small matching loss near UHF low band 252b and at a frequency of a GPS signal while producing a large matching loss in UHF mid band 252c and UHF high band 252d.

Fig. 3B is a matching property diagram of antenna matching unit 105 according to the first embodiment of the present invention, where matching loss 253c in the UHF mid band 252c is minimized.

Matching property 255 provides a small matching loss near UHF low band 252c and at a frequency of a GPS signal while producing a large matching loss in UHF low band 252b and UHF high band 252d.

Fig. 3C is a matching property diagram of antenna matching unit 105 according to the first embodiment of the present invention, where matching loss 253d in the UHF high band 252d is minimized.

Matching property 257 provides a small matching loss near UHF high band 252d and at a frequency of a GPS signal while producing a large matching loss in UHF low band 252b and UHF mid band 252c.

These properties result in a small matching loss between small-size antenna 103 and active element 117, and efficient transmission of a reception signal to tuner unit 109, thereby providing a favorable reception sensitivity of UHF TV broadcasting signals and GPS signals.

Here, capacitors 155, 161, 165 are changed with switches 153, 159, 163 serially connected, respectively. Alternatively, the capacitance value may be continuously changed by connecting capacitor 155a (not shown) between signal line 115c and parallel resonance circuit 169 such as with a varicap diode provided. In this case, the matching loss can be reduced according to the reception frequency of UHF broadcast signal 252a as shown in Fig. 3A.

With antenna matching device 115 or antenna matching unit 105 moduled on a single board, influence by wiring other than that of the module and an extraneous high-frequency signal can be reduced, thereby implementing high stability, low loss, and high isolation.

Further, with antenna matching device 115 or antenna matching unit 105 shielded against high frequencies by a metal case or metal plating, influence by an extraneous high-frequency signal can be reduced, thereby decreasing design limitation in handling high-frequency signals.

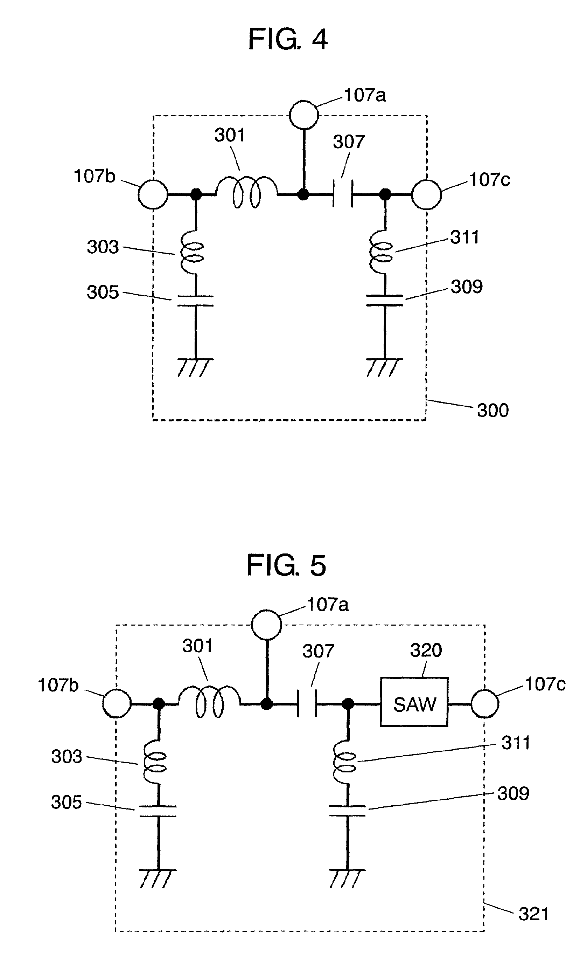

Fig. 4 is a circuit diagram of a distribution filter included in a high-frequency receiving unit according to the first embodiment of the present invention. In Fig. 4, between input terminal 107a and output terminal 107b, inductor 301 connected between input terminal 107a and output terminal 107b; and a series-connected element composed of inductor 303 and capacitor 305 between output terminal 107b and the ground form an inductive M-type low-pass filter. Between input terminal 107a and output terminal 107c, capacitor 307 connected between input terminal 107a and output terminal 107c; and a series-connected element composed of inductor 311 and capacitor 309 between output terminal 107c and the ground form an inductive M-type high-pass filter.

When a UHF signal and a GPS signal, for example, are input to the input terminal, this distribution filter 300 allows a UHF signal to be output from output terminal 107b and a GPS signal to be output from output terminal 107c.

Fig. 5 is another circuit diagram of a distribution filter included in the high-frequency receiving unit according to the first embodiment of the present invention. Instead of distribution filter 300 in Fig. 4, distribution filter 321 is shown formed by inserting SAW filter 320 for GPS signals between capacitor 307 and output terminal 107c. This distribution filter 321 allows a GPS signal with its disturbing signal adequately suppressed to be output from output terminal 107c.

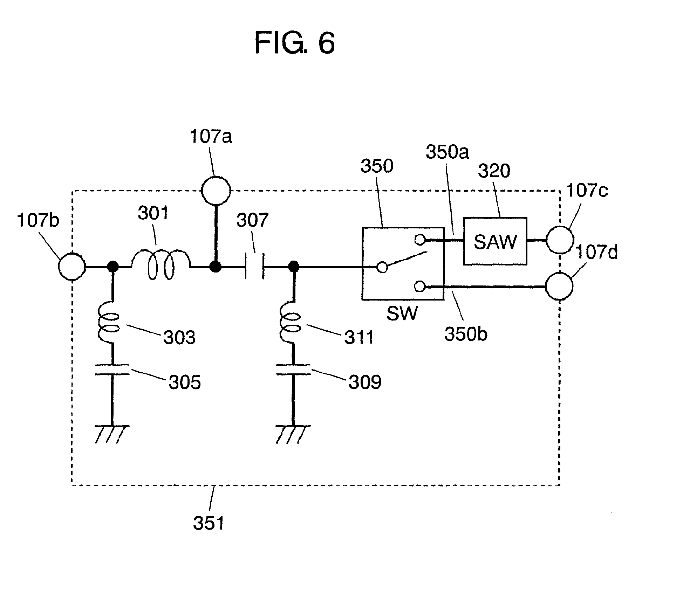

Fig. 6 is yet another circuit diagram of a distribution filter included in the high-frequency receiving unit according to the first embodiment of the present invention. In addition to Fig. 5, distribution filter 351 is shown formed by inserting switch (SW) 350 between capacitor 307 and SAW filter 320.

With distribution filter 351, a first signal output from output 350a of switch 350 is connected to output terminal 107c through SAW filter 320, and a second signal output from output 350b of switch 350 is directly connected to output terminal 107d. Using distribution filter 351 allows such as a cellular's MIMO (Multi Input Multi Output) reception signal to be selected from output terminal 107d.

Here, switch 350 is attached between input terminal 107a and output terminal 107c. However, switch 350 may be attached between input terminal 107a and output terminal 107b according to a frequency handled.

With distribution filters 300, 321, 351 shown in Figs. 4 through 6 moduled on a single board, influence by wiring other than that of the module and an extraneous high-frequency signal can be reduced, thereby implementing high stability, low loss, and high isolation.

Further, with distribution filters 300, 321, 351 shielded against high frequencies by a metal case or metal plating, influence by an extraneous high-frequency signal can be reduced, thereby decreasing design limitation in handling high-frequency signals.

As described above, when receiving a high-frequency signal composed of a UHF TV broadcasting signal and a GPS signal, for example, with frequency 252e higher than that of this UHF TV broadcasting signal by small-size antenna 103, antenna matching device 115 capable of minimizing matching loss in a GPS signal and UHF TV broadcasting signal; and antenna matching unit 105 formed of active element 117 connected to the output of antenna matching device 115 are provided between antenna 103 and the receiving unit, where antenna 103 is small-size antenna 103 with a length of approximately one-quarter the wavelength of the GPS signal.

Then, antenna matching device 115 is provided with signal line 115c placed between the input and output; parallel resonance circuit 169 connected between signal line 115c and the ground; and capacitor 155, for example, inserted serially to parallel resonance circuit 169. Further, the parallel resonance frequency of this parallel resonance circuit is set to a value roughly the same as frequency 252e of the GPS signal, and the series resonance frequency produced by parallel resonance circuit 169 and capacitor 155 is set to a value lower than that of the UHF TV broadcasting signal.

When receiving a GPS signal, such a structure minimizes matching loss between antenna 103 and active element 117 while suppressing signals other than a GPS signal by means of parallel resonance circuit 169. When receiving a UHF TV broadcasting signal, the antenna matching unit minimizes matching loss between antenna 103 and active element 117 by changing the capacitance value of capacitor 155.

In the first embodiment of the present invention, the description is made of a case of receiving a UHF TV broadcasting signal and a GPS signal. However, the present invention is also generally applicable to a case of receiving a first high-frequency signal with a broad band width and a second high-frequency signal with a band width narrower than that of the first high-frequency signal, with a frequency higher than that of the first high-frequency signal.

The description is made of a case of small-size antenna 103 with a length one-quarter the wavelength of a GPS signal. However, a small-size antenna may be used with a length shorter than a length one-quarter the wavelength of a GPS signal. In this case, in Fig. 2A, output impedance 201 of antenna 103 separates from center 205 (50 Ω) to approach outer circumferential circle 207, and impedance 201d separates from center 205 for a GPS signal, for example. On the other hand, in Fig. 1, inserting an element for converting impedance serially to signal line 115c minimizes matching loss.

Additionally, output impedance 201 of antenna 103 is known to change depending such as on the positional relationship with a display unit (not shown) displaying images, placed close to antenna 103, on the shape of a board containing antenna 103, and on the position of attaching antenna 103. For example, when receiving television on a mobile phone, the display unit for displaying images can be rotated in portrait, landscape, or turn-around orientation for viewing. When recording television, reception may be made with the display unit closed.

In these cases, the positional relationship between antenna 103 and the display unit varies depending on a case, causing the output impedance of antenna 103 to be changed, which may prevent antenna matching device 115 from minimizing the matching loss. Hence, the matching loss is required to be minimized according to the arrangement relationship between antenna 103 and its surrounding casing when viewing or recording video.

For this purpose, a table for switch control is preliminarily provided correspondingly to the arrangement of antenna 103 and its surrounding casing and to a reception band (wide frequency band). Then, with antenna matching device 115 controlled on the basis of the table, matching loss between antenna 103 and active element 117 can be always minimized.

An antenna matching unit and a high-frequency receiving unit including the antenna matching unit, according to the present invention offer an advantage in which matching loss is minimized for wide-band reception signals, especially useful for the TV receiver such as of a mobile phone.

## Claims

1. An antenna matching unit receiving a first high-frequency signal having a first band width; and a second high-frequency signal with a frequency higher than that of the first high-frequency signal, having a second band width smaller than the first band width, by means of an antenna with a length of one-quarter or less a wavelength of the high-frequency signal, comprising:
an input terminal to which the high-frequency signal from the antenna is input;
an antenna matching device connected to the input terminal and minimizing matching loss;
an active element to which an output signal from the antenna matching device is connected and to which the high-frequency signal is input; and
an output terminal from which an output from the active element is connected,
wherein the antenna matching device includes:
a signal line placed between the input terminal and the output terminal;
a series-connected element including a first capacitor and a first inductor, both connected between the signal line and the ground;
a second capacitor connected in parallel with the first inductor; and
a control terminal for changing a capacitance value of the first capacitor, and
wherein a parallel resonance frequency between the first inductor and the second capacitor is set to a frequency of the second high-frequency signal, and a capacitance value of the first capacitor is changed to reduce matching loss in the first high-frequency signal.

2. The antenna matching unit of claim 1, wherein a capacitance value of the first capacitor can be continuously changed according to a control voltage from the control terminal.

3. The antenna matching unit of claim 1, further comprising a plurality of series-connected elements each including a capacitor and a switch, wherein a capacitance value of the first capacitor is selected by controlling the switch according to a control voltage from the control terminal.

4. The antenna matching unit of claim 1, wherein an optimum control voltage is preliminarily provided according to an arrangement mode of the antenna and a casing surrounding the antenna, and the antenna matching device is controlled according to the control voltage.

5. The antenna matching unit of claim 1, wherein an element for converting impedance is inserted serially to the signal line of the antenna matching device to minimize matching loss in the second high-frequency signal.

6. The antenna matching unit of claim 1,
wherein the first high-frequency signal is a UHF TV broadcasting signal, and
wherein the second high-frequency signal is a GPS signal.

7. A high-frequency receiving unit to which an input from the antenna matching unit of claim 1 is connected, comprising:
a distribution filter to which an output from the antenna matching unit is connected and that separates into the first high-frequency signal and the second high-frequency signal and outputs them,
wherein the antenna matching unit and the distribution filter are mounted on a same board, and
wherein at least one of the antenna matching device, the antenna matching unit, and the distribution filter is shielded.

8. A high-frequency receiving unit to which an output from the antenna matching unit of claim 1 is connected, comprising:
a distribution filter separating into the first high-frequency signal and the second high-frequency signal and outputting them;
a first receiving circuit to which the first high-frequency signal output from the distribution filter is fed; and
a second receiving circuit to which the second high-frequency signal output from the distribution filter is fed.
